# EUROPEAN PATENT SPECIFICATION

(11) **EP 2 487 275 B1**
(45) Date of publication and mention of the grant of the patent: **15.06.2016**
(21) Application number: 12152912.7
(22) Date of filing: 27.01.2012
(51) Int. Cl.: C23C 14/56, H01J 37/32

(54) **Composite shielding**
Verbundstoffabschirmung
Blindage composite

(30) Priority: 11.02.2011 GB 201102447; 17.02.2011 GB 201102747
(43) Date of publication of application: 15.08.2012
(73) Proprietor: SPTS Technologies Limited, Newport Gwent NP18 2TA (GB)
(72) Inventor: Widdicks, Clive, Bristol, BS9 4PP (GB); Moncrieff, Ian, Wickwar, GL12 8NH (GB)
(74) Representative: Wynne-Jones, Laine and James LLP

(56) References cited:
- EP-A2- 0 853 331
- EP-A2- 1 953 798
- US-A1- 2009 260 982
- US-B1- 6 231 674

## Description

Shielding design is an important factor in the reliable operation of PVD tools. The shielding has to contain deposited material, to avoid deposition on the chamber walls for example, retain this material for as long as possible, ideally a full target life without release of particles, be simple to replace, be low cost and have no adverse effect on the film coating on the wafer.

Typically stainless steel shielding is used in PVD systems as robust, relatively complex assemblies can be constructed which can be simple to install in the process chamber and are relatively cost effective as they can be cleaned and re-used.

When high power deposition processes are carried out, i.e. >30kW, the heat load on the stainless steel shielding can cause distortion (due to the fact that stainless steel is a relatively poor thermal conductor) which in turn will result in particles being ejected from the shielding. This is not acceptable for standard operating conditions. While shielding could be made from a metal with better thermal properties, e.g. Aluminium this tends to be costly to fabricate and impractical to clean. Cleaning aluminium is difficult and when tight dimensional tolerance is important (to maintain film uniformity on the wafer for example) it is not practical to re-use the material.

EP1953798 discloses a process kit comprising a shield and ring assembly positioned about a substrate support in a processing chamber to reduce deposition of process deposits on internal chamber components and an overhang edge of the substrate.

The invention seeks to provide a practical solution for high power deposition process by using a composite shielding assembly. The shielding assembly uses both stainless steel and aluminium components which when installed in the system behave as a single assembly. In the regions where the heat load is high aluminium is used. This enables prolonged high power operation while maintaining excellent process performance. When the shielding is to be changed the aluminium part may be disposed of while the stainless steel assembly is cleaned and re-used.

Thus from one aspect the invention consists in a composite shield assembly for use in deposition apparatus defining a workpiece location the assembly, including:
a first shield element for positioning circumjacent the workpiece location; and
a second shield element for extending around and carrying the first element wherein the thermal conductivity of the first element is greater than that of the second element and the elements are arranged for intimate thermal contact;
wherein the first element is aluminium or an alloy thereof and the second element is stainless steel, and the first element is a press or friction fit in the second element.

It will be understood that a shield element is a bulk structure and not merely a coating.

The invention also includes a deposition chamber including a workpiece location and an assembly as defined above.

The second element may mount the first on a wall of the chamber. The first element may lie circumjacent the workpiece location to constitute a shadow shield. The second element may form a shield for part of the chamber.

Although the invention has been defined above it is to be understood it includes any inventive combination of the features set out above or in the following description.

The invention may be performed in various ways and a specific embodiment will now be described, by way of example, with reference to the accompanying drawings in which:
Figure 1 is a vertical section through one half of a part of a Physical Vapour Deposition (PVD) chamber;
Figure 2(a) is a perspective view of an aluminium element of the shield assembly, Figure 2(b) is a view from above of that assembly and Figure 2(c) is a cross section of the line A-A in Figure 2(b);
Figure 3 is a graph of thickness uniformity as a function of target life; and
Figure 4 is a graph indicating deposition thicknesses with respect to the wafer edge.

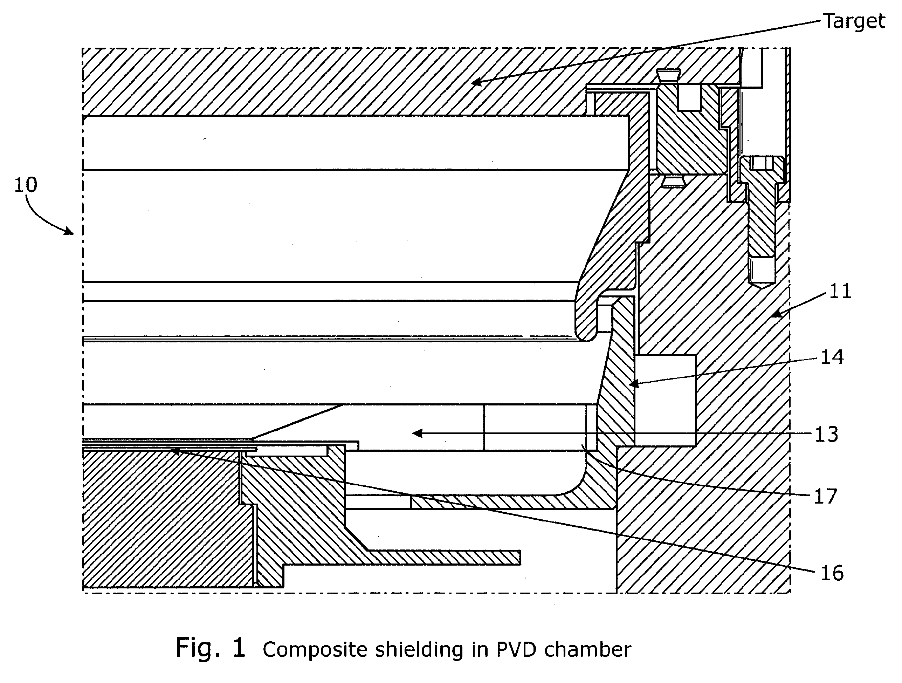

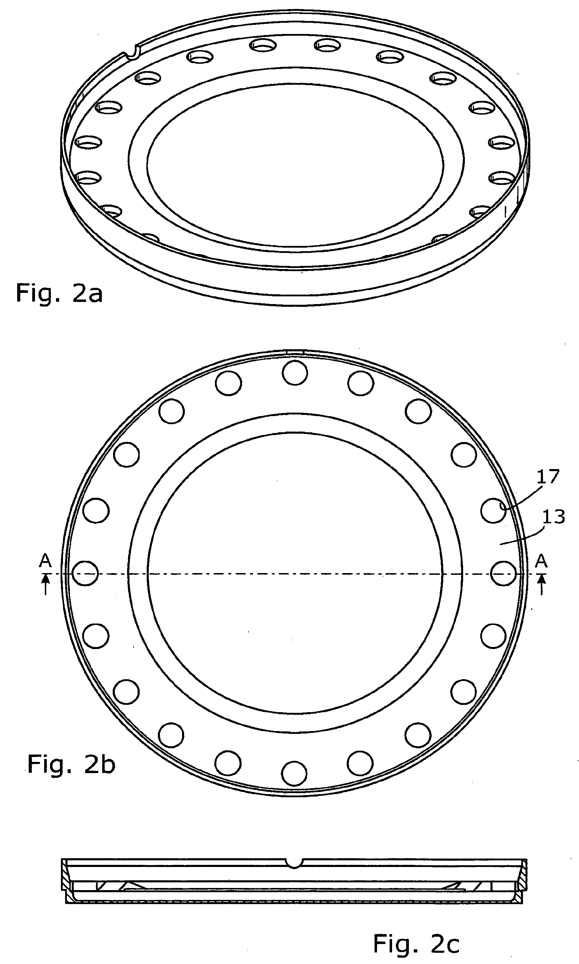

Fig 1. shows the composite assembly 10 in a PVD process chamber 11. An Al shield element 13 is placed above the wafer, at a wafer location 16, in the region where the heat flux is typically at a maximum for the shielding. The shield element 13 acts as a shadow shield. The Al shield element 13 is held there by a stainless steel shield element 14 to form the assembly 10. The stainless steel shield element 14 extends along the wall of the chamber 11 and beneath the Al shield element 13. Parts need to be a very tight fit (press fit (spec +0.1 to +0.3mm) as indicated in fig 2) to ensure the full benefits of the composite are realized. I.e. coupling between Al 13 and stainless steel 14 needs to intimate (as the shielding heats up the Al shield element 13 expands into the stainless steel shield element 14 and provides an even better thermal contact). Contact between the outer stainless steel shielding and the inner wall of process chamber needs to be achieved for optimum dissipation of the heat generated during the deposition cycle. Note if the complete shielding was solely made from Al this would be a serious problem as it would tend to weld, for example friction weld, to the process chamber wall and be very difficult to remove during maintenance. The Al shield element 13 has a number of openings 17 to enable efficient pumping of the chamber.

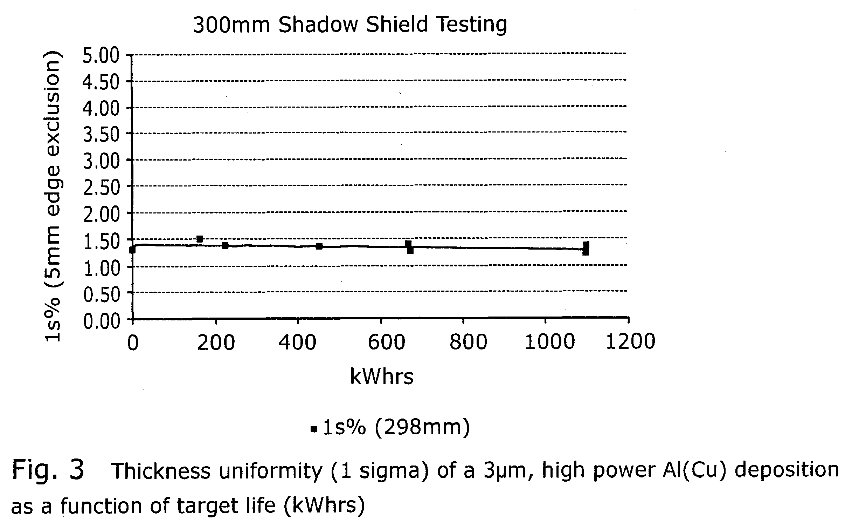

Figure 3. show the excellent uniformity performance of the shielding over ~1100kWhrs of high power 3µm, 40kW Al(Cu) deposition.

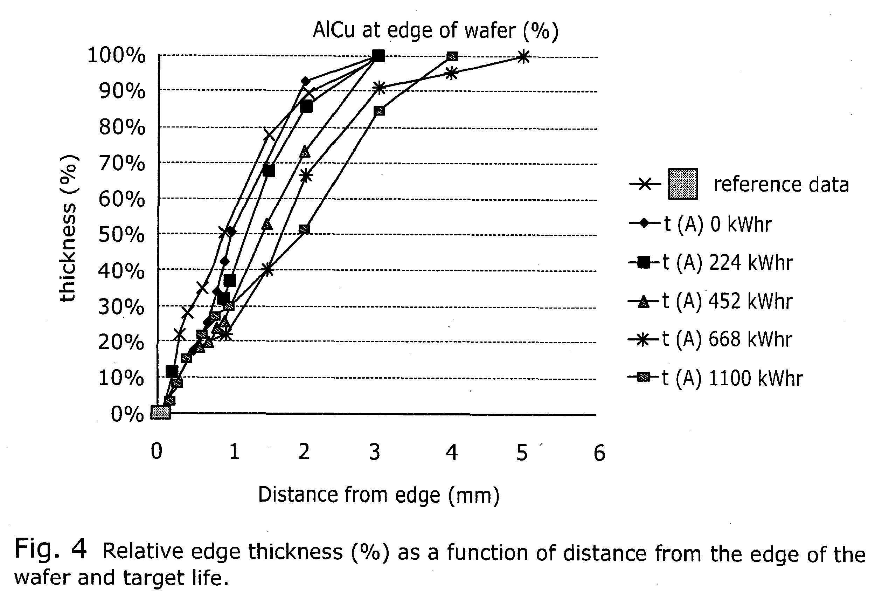

Distortion of the shielding close to the wafer edge (ie. the Al shield element 13) would adversely affect the thickness of the deposition at the edge of the wafer. As Figure 4 shows uniformity edge uniformity is maintained at the desired 100% level throughout the 1100kWhrs with a 5mm edge exclusion value.

It should be noted that:
1) Once thermally cycled the press fit parts behave like a single component.
2) Due to the Al ring being in close proximity to the wafer and the location of the stainless steel in contact with the Al chamber wall the thermal performance of the shielding is improved over a conventional stainless steel component. This enables high power deposition processes to be run for longer in production than would otherwise be the case.
3) Once the shielding needs to be changed the Al shield 13 can be replaced while the stainless steel exterior shielding can be cleaned and re-used.

## Claims

1. A composite shield assembly (10) for use in deposition apparatus (11) defining a workpiece location (16), the assembly including:
a first shield element (13) for positioning circumjacent the workpiece location; and
a second shield element (14) for extending around and carrying the first element wherein the thermal conductivity of the first element is greater than that of the second element and the elements are arranged for intimate thermal contact;
wherein the first element is aluminium or an alloy thereof and the second element is stainless steel, and the first element is a press or friction fit in the second element.

2. A deposition chamber including a workpiece location and an assembly as claimed in claim 1.

3. A chamber as claimed in claim 2 wherein the second element mounts the first element on a wall of the chamber.

4. A chamber as claimed in claim 2 or claim 3 wherein the first element lies circumjacent the workpiece location to form a shadow shield.

5. A chamber as claimed in any one of claims 2 to 4 wherein the second element forms a shield for part of the chamber wall.

6. A high power deposition apparatus including an assembly as claimed in any one of the preceding claims.

7. Apparatus as claimed in claim 6 having a power supply for delivery >30kW.

## Patentansprüche

1. Verbundstoffabschirm-Vorrichtung (10) zur Verwendung in einer Abscheidungsapparatur (11), die einen Werkstückort (16) bildet, **dadurch gekennzeichnet, daß** die Vorrichtung folgende Elemente aufweist: ein erstes Abschirmelement (13) zur Positionierung rund um den Werkstückort und ein zweites Abschirmelement (14), das sich rund um das erste Element erstreckt und dieses erste Element trägt, wobei die Wärmeleitfähigkeit des ersten Elementes größer ist als diejenige des zweiten Elementes und die Elemente so angeordnet sind, daß sie in engem Wärmekontakt stehen, wobei das erste Element Aluminium ist oder eine Ableitung davon und das zweite Element rostfreier Stahl ist, und wobei das erste Element auf dem zweiten Element einen Preßsitz oder Reibungssitz hat.

2. Abscheidungskammer mit einem Werkstückort und einer Vorrichtung gemäß Anspruch 1.

3. Kammer nach Anspruch 2, **dadurch gekennzeichnet, daß** das zweite Element das erste Element auf einer Wand der Kammer trägt.

4. Kammer nach Anspruch 2 oder 3, **dadurch gekennzeichnet, daß** das erste Element rund um den Werkstückort liegt, um einen Schattenschirm zu bilden.

5. Kammer nach einem der Ansprüche 2 bis 4, **dadurch gekennzeichnet, daß** das zweite Element für einen Teil der Kammerwand einen Schirm bildet.

6. Hochdruckabscheidungs-Einrichtung mit einer Vorrichtung gemäß einem der vorhergehenden Ansprüche.

7. Einrichtung nach Anspruch 6, **dadurch gekennzeichnet, daß** sie eine Stromzufuhr zur Abgabe von > 30 kW hat.

## Revendications

1. Ensemble blindage composite (10) pour une utilisation dans un appareil de dépôt (11) définissant un emplacement de pièce (16), l'ensemble comprenant :
un premier élément de blindage (13) destiné à être positionné sur le pourtour de l'emplacement de pièce ; et
un second élément de blindage (14) destiné à s'étendre autour et à porter le premier élément, la conductivité thermique du premier élément étant supérieure à celle du second élément et les éléments étant agencés pour un contact thermique étroit ;
le premier élément étant en aluminium ou un alliage de celui-ci et le second élément étant en acier inoxydable, et le premier élément étant à ajustement pressé ou serré dans le second élément.

2. Chambre de dépôt comprenant un emplacement de pièce et un ensemble selon la revendication 1.

3. Chambre selon la revendication 2, dans laquelle le second élément monte le premier élément sur une paroi de la chambre.

4. Chambre selon la revendication 2 ou la revendication 3, dans laquelle le premier élément repose sur le pourtour de l'emplacement de pièce pour former un blindage partiel.

5. Chambre selon l'une quelconque des revendications 2 à 4, dans laquelle le second élément forme un blindage pour une partie de la paroi de chambre.

6. Appareil de dépôt à haute puissance comprenant un ensemble selon l'une quelconque des revendications précédentes.

7. Appareil selon la revendication 6 ayant une alimentation électrique pour une distribution > 30 kW.
